# EUROPEAN PATENT SPECIFICATION

(11) **EP 3 787 100 B1**
(45) Date of publication and mention of the grant of the patent: **23.04.2025**
(21) Application number: 19194690.4
(22) Date of filing: 30.08.2019
(51) Int. Cl.: H01P 1/02

(54) **REDIRECTING DEVICE FOR MM-WAVES, CONNECTION ASSEMBLY**
ABLENKVORRICHTUNG FÜR MM-WELLEN, VERBINDUNGSANORDNUNG
DISPOSITIF DE REDIRECTION D'ONDES MM, ENSEMBLE DE CONNEXION

(43) Date of publication of application: 03.03.2021
(73) Proprietor: TE Connectivity Germany GmbH, 64625 Bensheim (DE)
(72) Inventor: RUSCH, Christian, 67105 Schifferstadt (DE); BERGNER, Bert, 64625 Bensheim (DE)
(74) Representative: Grünecker Patent- und Rechtsanwälte PartG mbB

(56) References cited:
- EP-A1- 0 767 507
- EP-A1- 3 462 533
- WO-A1-2014/099389
- CN-A- 1 365 160
- US-A1- 2014 285 277
- US-A1- 2017 170 539
- US-A1- 2018 040 936

## Description

The invention relates to the area of redirecting mm-waves, that is, waves having a wavelength of 1 to 10 mm. Such waves are, for example, used in mobile communication (5G) or for radar signal transmission. For the transmission of such waves, flexible elements can be used. When such flexible elements are connected to other elements, for example a PCB, the assembly is very bulky.

In order to provide a solution that allows a more space saving connection, a redirecting device for mm-waves, can comprise an input section, an output section and a rigid, dielectric waveguide member extending from the input section to the output section, wherein the input section and the output section are at 90 degrees to each other.

With this solution, flexible elements no longer have to be attached perpendicular to the other element, for example the PCB, but can rather be installed such that they run parallel to it. Such an arrangement is thus more space saving.

US 2014/285277 A1 shows a waveguide with a reflector at a curve. EP 0 767 507 A1 shows a bent waveguide supported between two boards. In US 2017/170539 A1, a wave is guided in a central element that is surrounded by a cladding. WO 2014/099389 A1 relates to shielding structures for electrical conductors.

The object of the invention is to provide a solution that allows an easy manufacturing while the waveguide member is supported.

According to the invention, this is achieved with a redirecting device according to the claims.

A connection assembly comprises a redirecting device according to the invention.

The support structure supports the waveguide member. Due to the fact that the entire redirecting device including the support structure is a single monolithic piece, it is easy to manufacture.

The solution according to the invention can further be improved by the following further developments and advantageous embodiments, which are independent of each other and can be combined arbitrarily, as desired.

To improve the stability, the input section and the output section can be mechanically connected to each other. For example, they can be connected rigidly so that they cannot move relative to each other.

The waveguide member can be a solid element. In contrast, for example, to a hollow waveguide member, a solid waveguide member can be manufactured more easily.

In a simple design, the input section and/or the output section can comprise planar end surfaces of the waveguide member

In order to achieve an easy coupling, the input section can comprise a first coupling face for coupling to a first external member and the waveguide member extends away from the first coupling face. The first coupling face can in particular be planar or flat to achieve a good coupling efficiency. The first external member can, in particular, be a cable or a flexible element like a dielectric waveguide. The waveguide member can preferably extend away perpendicularly from the first coupling face.

Similarly, the output section can comprise a second coupling face for coupling to a second external member, and the waveguide member can extend away from the second coupling face .The second coupling face is also preferably planar and the waveguide member extends preferably perpendicularly away from the second coupling face. The second external member can be a PCB (printed circuit board). The PCB can, for example, comprise wave-emitting elements like an antenna.

Preferably, the first and the second coupling face are 90 degrees to each other. This can simplify the coupling.

In a simple design, the waveguide member can run along a 90 degree curve. The curve can have a constant radius to make the production simple. The waveguide member can comprise one or more curves with an angle different from 90 degrees, or straight sections.

In order to avoid disturbances, the waveguide member can have a low or no elastic and plastic deformability. It can, for example, not be as flexible as a flexible element attached to it, for example a dielectric waveguide.

For a good volume-to-length ratio, the waveguide member may be an elongated element. One dimension of the waveguide member can be larger than the other two dimensions by a factor of at least five. For example, the waveguide member can have a length that is larger than its width and/or height by a factor of at least five. The length can here be measured along a non-straight line, for example a curved line.

The waveguide member may have a constant cross-section. This can result in good transmission characteristics. The cross-section, in particular the shape of the cross-section and the area of the cross-section, can be constant from the input section to the output section. The cross-section can be taken perpendicular to a length extension of the waveguide member. The cross-section in a plane comprising a width and a height can thus be constant along the length direction.

The waveguide member can have various cross-sections. For example, a circular, an elliptical, or a rectangular shape are possible for transmitting different modes and orientations of the waves.

In order to be adapted for the transmission of mm-waves, a dimension of the cross-section can be greater than 0.2 times the wavelength. and/or less than 1.5 times the wavelength. The wavelength can in particular relate to the wavelength that is to be transmitted.

To minimize losses, the cross-section of the input section and/or the output section can be similar or identical to the cross-section of the waveguide member.

Also to minimize losses, the cross-section of the waveguide member can be adapted to the cross-section of an attached waveguide, in particular the core of such a waveguide.

To achieve a sufficient performance in the mm-range, a minimum curvature radius of the waveguide member can be greater than one wavelength.

The waveguide member can, in particular, be curved in a plane that comprises a length direction.

The redirecting device can comprise a planar sheet or board member located at or next to the input section and/or the output section. The board member can serve as a fixation element or a closure element when the redirecting device is attached to an external element. The board member can extend away from the input section or the output section to an extent that an open end of the attached external element is covered.

The redirecting device comprises a support structure for supporting the waveguide member.

The support structure can extend along the waveguide member from the input section to the output section, preferably continuously and/or uninterruptedly.

In one embodiment, the input section defines a first mounting plane and/or the output section defines a second mounting plane and the support structure extends from the waveguide member to the first mounting plane and/or the second mounting plane. This increases the stability of the waveguide member. The first mounting plane may be perpendicular to the second mounting plane.

For improving the transmission performance, the support structure can enclose an air cladding and/or an air volume. Preferably, the air cladding and/or the air volume extends to the first mounting plane and/or the second mounting plane.

In a lightweight embodiment having a good transmission performance, apart from the input section, the output section, and the support structure, no further material may be present next to the waveguide member. The expression *"next to"* can be understood as within 0.5 times the wavelength and/or a maximum width of waveguide member.

In an alternative embodiment with a similarly good transmission performance, material with a low permittivity, e.g. foam, can be present next to the waveguide member. Such a material with a low permittivity can act as a spacer, ensuring that no material or elements with high permittivity can come close to the waveguide member and disturb the transmission performance.

In a preferred embodiment, in which the transmission performance is improved, in a cross-section, the thickness of a part of the support structure extending away from the waveguide member is less than 20% of a maximum thickness of the waveguide member. The thickness can, for example, be measured at a distance of 0.5-times the wavelength away from the waveguide member. The thickness of this part can be measured in a circumferential direction. Preferably, the thickness of a part of the support structure extending away from the waveguide member is less than 10% of a maximum thickness of the waveguide member, especially 5%.

Also for improving the transmission performance, in a cross-section, any part of the support structure extending away from the waveguide member can make up less than 30 degrees, preferably less than 20 degrees, more preferably less than 10 degrees. The angle can be measured at a distance of 1.0 times the wavelength away from the waveguide member taking the center of the waveguide member as the vertex of the angle. The sum of different angles of different parts in total can be less than 90 degrees, preferably less than 60 degrees, more preferably less than 45 degrees.

The support structure can comprise a web, a strut, or a sheet-like element to maintain a low weight.

To reduce the weight further while providing sufficient stability and improving the transmission performance, a part of the support structure extending away from the waveguide member can taper towards the waveguide member.

In a preferred embodiment, the support structure comprises two parts extending away from the waveguide member and extending away from each other. This results in a good compromise between stability and weight. Preferably, the two parts extend away from each other at an angle. The angle can, for example, be 90 degrees or 60 degrees.

A first part of the two parts can be connected to a first wall section and a second part of the two parts can be connected to a second wall section. The first wall section and the second wall section can run parallel to each other. They can extend up to the first mounting plane and/or the second mounting plane.

For waveguide members with a rectangular cross section, a fixation point at which a part of the support structure is attached to the waveguide member should preferably be located at a corner of the rectangle, as the energy density there is low and the losses are thus minimal.

In order to keep the weight down, the support structure can be arranged at an inner side of a curve of the waveguide member.

The waveguide member and the support structure are integral or one-piece in order to facilitate manufacturing.

The redirecting device is configured to be moldable with a two-piece die. This simplifies the production. For example, a demolding direction can exist, along which no undercuts are present, such that the redirecting device can be removed from the two pieces of the die.

The redirecting device is a single monolithic piece. This can make the production easy. Preferably, the redirecting device comprises only plastic, and no other materials like metal. Especially, the redirecting device can be a monolithically moulded piece.

The connection assembly can further comprise a housing element, wherein the housing element is spaced at least 1.0 times the wavelength away from the waveguide member, at any point. This can improve the transmission performance as undesired coupling is avoided.

The housing can be integral with the redirecting device. Both can be a single monolithic part.

The invention will now be described in greater detail and in an exemplary manner using advantageous embodiments and with reference to the drawings. The described embodiments are only possible configurations in which, however, the individual features as described above can be provided independently of one another or can be omitted.

In the Figs.:
- Fig. 1: shows a schematic perspective view of a first embodiment of a redirecting device in a mounted state;
- Fig. 2: shows a schematic perspective view of a second embodiment of a redirecting device;
- Fig. 3: shows a schematic perspective view of the second embodiment of Fig. 2 from a different viewpoint;
- Fig. 4: shows a schematic perspective view of a calculation of an e-field distribution in the second embodiment;
- Fig. 5: shows a schematic perspective view of a third embodiment of a redirecting device;
- Fig. 6: shows a schematic perspective view of a fourth embodiment of a redirecting device;
- Fig. 7: shows a schematic perspective view of a fifth embodiment of a redirecting device;
- Fig. 8: shows a schematic cross-sectional view of a sixth embodiment of a waveguide that can be attached to a redirecting device;
- Fig. 9: shows a schematic cross-sectional view of a seventh embodiment of a waveguide that can be attached to a redirecting device;
- Fig. 10: shows a schematic cross-sectional view of a third embodiment of a waveguide that can be attached to a redirecting device.

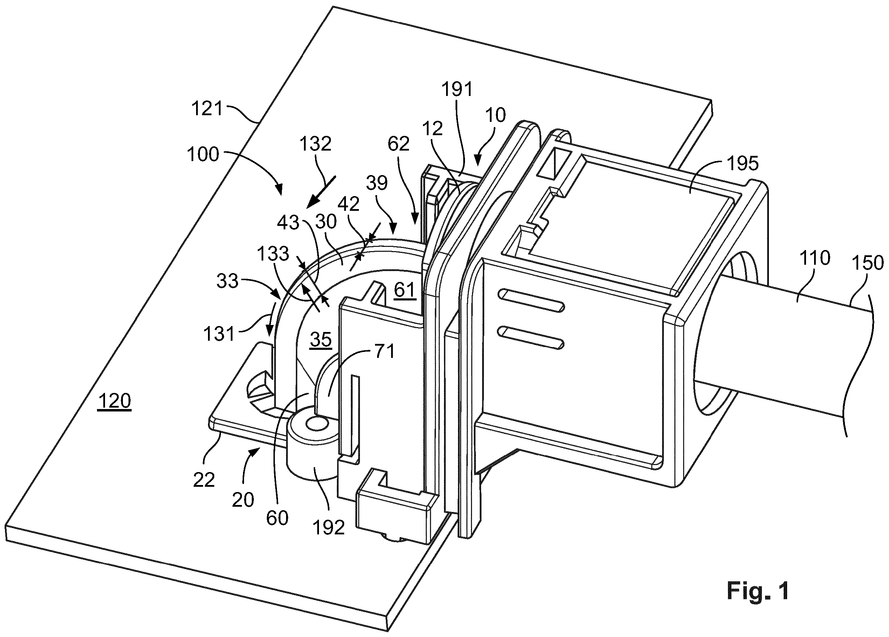

In Figs. 1 to 7, several embodiments of a redirecting device 100 are shown.

In Fig. 1, a first embodiment of a redirecting device 100 is shown together with further components. The redirecting device 100 comprises an input section 10 for connecting to a first external element 110, which in this case is a waveguide 150. Electromagnetic waves of certain frequencies can pass through the waveguide 150 and be directed to a second external element 120 located at output section 20 at an opposite side of the redirecting device 100. The second external element 120 is a PCB 121 in the depicted example.

For fixing the first external element 110 to the redirecting device 100, a plug 195 can be used. For a good connection, the redirecting device 100 can comprise a first fixing element 191. The redirecting device 100 further comprises a second fixing element 192 for connecting to the second external member 120. This second fixing element 192 can, for example, comprise a through-hole through which a bolt or similar element can be inserted.

The redirecting device 100 further comprises a rigid, dielectric waveguide member 30 extending from the input section 10 to the output section 20. The waveguide member 30 serves to guide the electromagnetic waves from the waveguide 150 to the element on the PCB 121 or from the element on the PCB 121 to the waveguide 150. For example, mobile communication signals can be created on the element on the PCB 121 and then be directed to a distribution element further away.

The input section 10 and the output section 20 are at 90 degrees to each other. This results in a space saving configuration, as the waveguide 150 can be parallel to the PCB 121.

To stabilize the configuration, the input section 10 and output section 20 are mechanically connected to each other. The waveguide member 30 has a low or no elastic and plastic deformability to improve the transmission performance. The waveguide member 30 can be a solid element. In contrast to a hollow element, such a solid element can be easier to produce.

The waveguide member 30 is an elongated element. The dimension in a length direction 131 that goes along a curve from the input section 10 to the output section 20 is greater by a factor of at least 5 than the dimensions in a width direction 132 and a height direction 133. The length direction 131, the width direction 132 and the height direction 133 are each perpendicular to each other at a certain point of the waveguide member 30. The absolute orientations of these directions however changes along the extension of the waveguide member 30.

The waveguide member 30 runs along a 90 degree curve 33. In an easy embodiment, the curve 33 could have a constant radius. However, the curvature radius can vary along the waveguide member 30. A minimum curvature radius 36 should not be below a certain limit in order to be able to appropriately transmit the mm-waves, which have wavelengths of approximately 1 to 10 mm in vacuum.

The redirecting device 100 comprises a support structure 60 for supporting the waveguide member 30. The support structure 60 extends along the waveguide member 30 from the input section 10 to the output section 20. In the depicted example, the support structure 60 extends continuously or uninterruptedly from the input section 10 to the output section 20. However, in an embodiment that is more lightweight, holes or recesses could be present in the material. The support structure 60 can comprise webs, struts and/or sheet-like sections. The support structure 60 can comprise or contain basically flat sections to keep the weight low.

The support structure 60 is arranged at an inner side 35 of the curve 33 of the waveguide member 30, in order to save space.

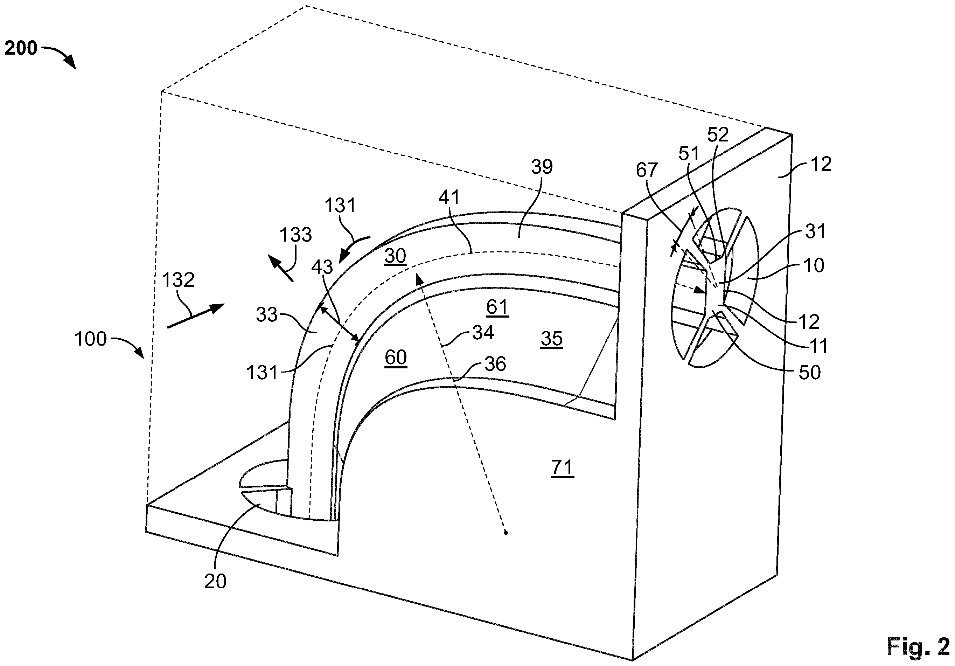

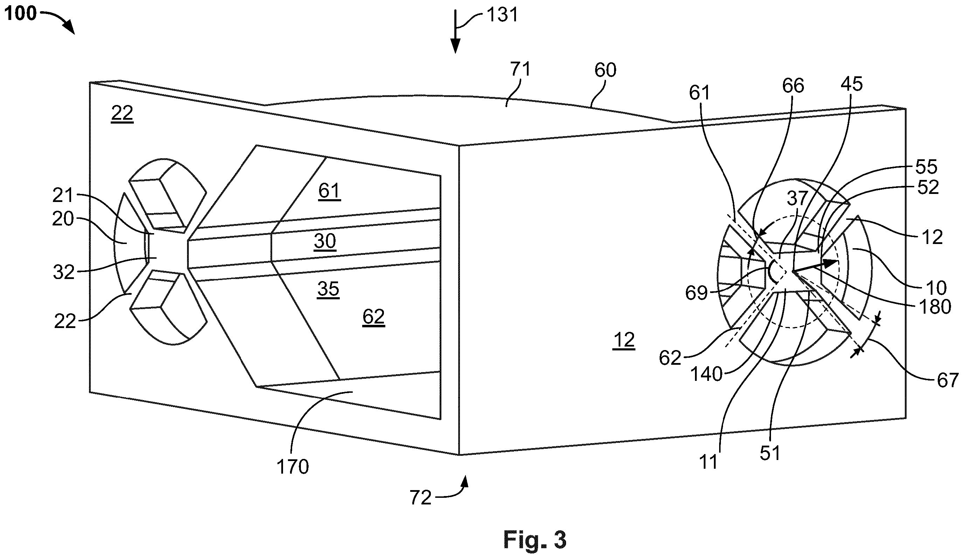

In Figs. 2 and 3, further details of an embodiment of the redirecting device 100 can be seen.

The input section 10 and the output section 20 comprise planar end surfaces 31, 32 of the waveguide member 30, which constitute a first coupling face 11 for coupling to the first external member 110 and a second coupling face 21 for coupling to the second external member 120. The waveguide member 30 extends away in a perpendicular manner from the first coupling face 11 and the second coupling face 21. The first coupling face 7 and the second coupling face 21 are 90 degrees to each other. The first coupling face 7 and the second coupling face 21 are configured to be in direct contact with further external elements, like the waveguide 150 and the element on the PCB 121.

The waveguide member 30 has a constant cross-section 140 from the input section 10 to the output section 20. Thus, the cross-section 140 of the input section 10 and the output section 20 are similar, in particular identical, to the cross-section 140 of the waveguide member 30.

In the embodiment shown in Figs. 2 and 3, the cross section 140 is rectangular. In other embodiments, the cross section 140 can have other shapes and, for example, be circular or elliptical. In order to achieve a good transmission, a dimension of the cross-section 140 should be within a certain range defined by the waves used with the redirecting device 100. Further, the cross-section 140 can be adapted to the waveguide 150, in particular to the cross-section of the core of the waveguide 150.

In order to minimize losses, fixation points 55, at which the support structure 60 is attached to the waveguide member 30, are located at corners 52 of the rectangular cross-section 140.

The input section 10 defines a first mounting plane 12 and the output section 20 defines a second mounting plane 22. The first coupling face 11 and the second coupling face 21 are flush with the first mounting plane 12 or the second mounting plane 22, respectively.

The support structure 60 extends from the waveguide member 30 to the first mounting plane 12, and the second mounting plane 22. The first mounting plane 12 is perpendicular to the second mounting plane 22.

The support structure 60 encloses an air volume or an air cladding 170. The fact that no material is present in this area results in a good transmission of the waves. In the depicted example, the air cladding 170 extends to the second mounting plane 22. In further embodiments, the air cladding 170 can also extend to the first mounting plane 12.

To avoid outcoupling of signals, and thus improve the signal, apart from the input section 10, the output section 20, and the support structure 60, no further material is present next to the waveguide member 30 (that means within a certain distance 183 from the waveguide member 30). The distance 183 can be dependent on the wavelength that is used. In alternative embodiments, a material with a low permittivity, e.g. foam, can be present next to the waveguide member 30 for achieving a similar effect.

The support structure 60 comprises two parts 61, 62 extending away from the waveguide member 30 and extending away from each other at an angle 69.

A first part 61 is connected to a first wall section 71 and a second part 62 is connected to a second wall section 22. The first wall section 71 and the second wall section 72 run parallel to each other.

As can, for example, be seen in Fig. 3, in a cross-section, the thickness 66 of the part 61 of the support structure 60 extending away from the waveguide member 30 is less than 20% of a maximum thickness 37 of the waveguide member 30. The maximum thickness 37 can, in this example, be the height 43 of the waveguide member 30 measured in a height direction 133. It could also be the width 42 or a radius.

The thickness 66 can be measured at a distance 180 away from a center of the waveguide member 30. It could also be measured from the outer surface of the waveguide member 30. The distance 180 can, for example, be defined by multiples of the wavelength. The thickness 66 can also be the thickness of the part 61, 62 directly next to the waveguide member 30. The thickness 66 of the first part 61 is measured in a circumferential direction. The thickness 66 of the first part 61 is also similar to the thickness of the second part 62 of the support structure 60 and to the thickness of further support elements present at the input section 10 or the output section 20.

Each of the parts 61, 62 of the support structure 60 extending away from the waveguide member 30 tapers towards the waveguide member 30, which means its thickness decreases towards the waveguide member 30.

The support structure 60 is arranged at an inner side 35 of the curve 33 of the waveguide member 30.

The redirecting device 100 is a single monolithic piece. It comprises only plastic, no metal, not even as a coating. This can simplify the production.

Embodiments of the redirecting device 100 can be configured to be moldable with a two-piece die. For example, a deformation direction can exist along which no undercuts are present. The redirecting device 100 can be a monolithically molded piece.

The first fixation element 191 is formed by a board member 185 of the redirecting device 100. The board member 185 is a planar sheet like section of the redirecting device 100 that is in the present case located next to the input section 10. A further board member 185 can be present at the output section 20. The board member 185 can serve to cover or close off attached external elements to avoid damages. The board member 185 extends away from the input section 10 sideways, towards the second mounting plane 22 and away from the second mounting plane 22.

A connection assembly 200 comprises a redirecting device 100 and can further comprise a housing element 190, wherein the housing element 190 is spaced a certain distance away from the waveguide member 30. The housing element 190 is, for example, shown schematically only in broken lines in Fig. 2.

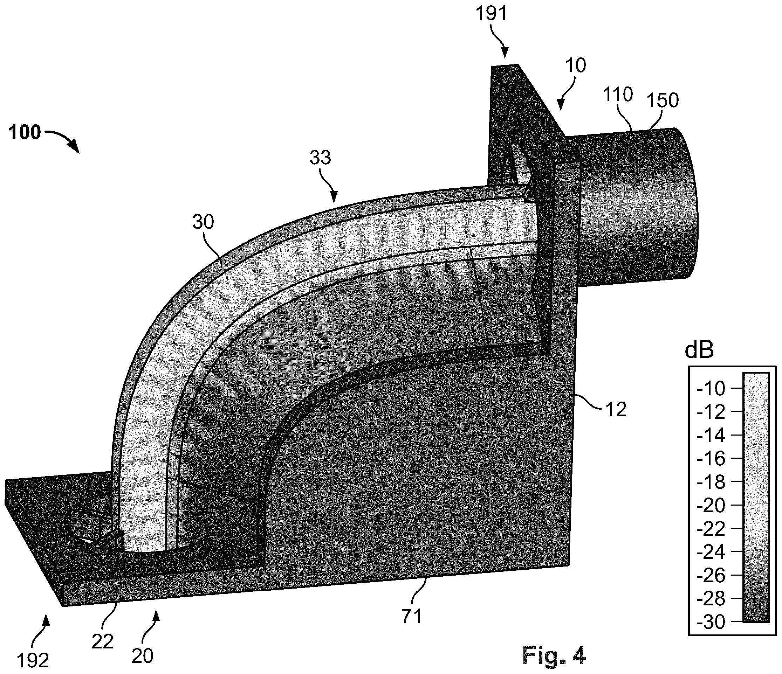

In Fig. 4, a visualization of a calculated distribution of the electric field in an embodiment of a redirecting device 100 is shown. It can be seen that only a small fraction of the field is present outside the waveguide member 30 so that the losses are low.

Further, a second fixing element 192 is similar to a first fixing element 91.

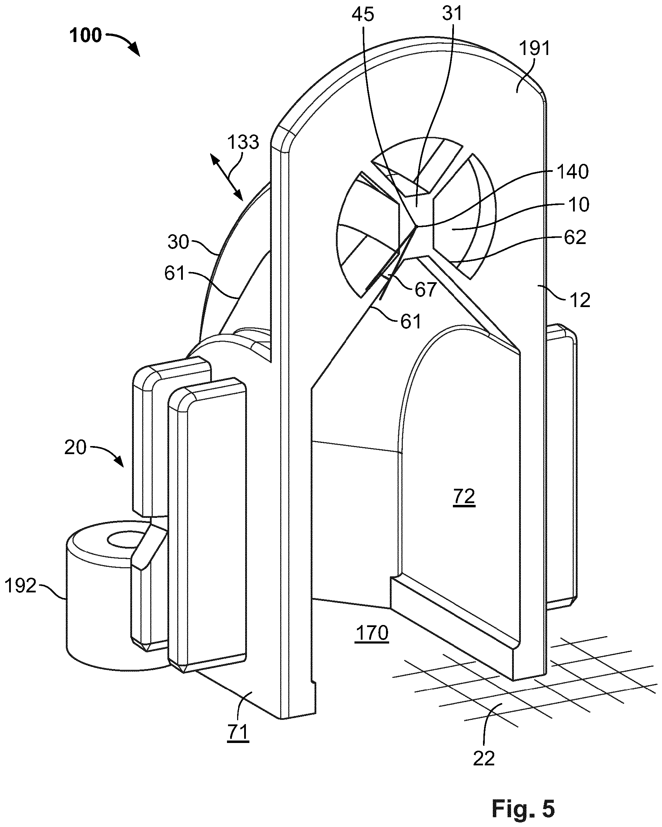

Several embodiments of a redirecting device 100 are shown in Figs. 5 to 7.

The embodiment shown in Fig. 5 is similar to the one in Fig. 1 and comprises a rectangular cross-section 140 of the waveguide member 30. It further comprises a fixing element 191 next to the input section 10 for fixing the redirecting device 100 to the first external element 110. The first fixing section 191 comprises a plate-shaped structure that can provide stop faces for a positive fit with corresponding elements on the external element 10 or a plug 195 attached to the external element 110.

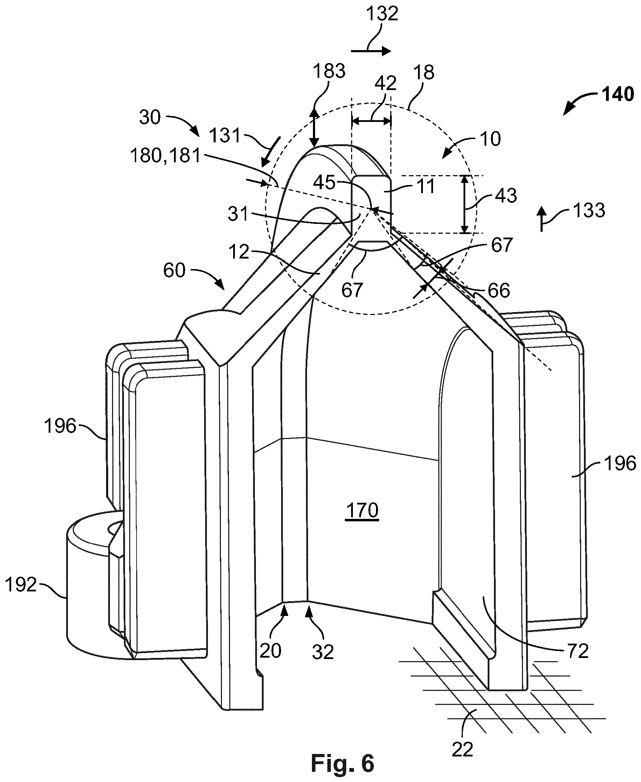

In the embodiment shown in Fig. 6, no such plate-shaped structure is present. Fixing can, for example, be achieved by further fixing elements 196 present at the sides of the redirecting device 100. This embodiment also has a rectangular cross-section 40.

It can further be seen that at a distance 181 away from the center of the waveguide member 30, the parts 61 and 62 of the support structure 60 that extend away from the waveguide member 30 each take up only a small angle 67 around the waveguide member 30, preferably less than 30°, for example about 20°. The angle 67 is in this case measured around a center 45 of the waveguide member 30, that means that the center of the waveguide member 30 is taken as the vertex of the angle 67. Further, the thickness 66 at the distance 180, 181 only makes up about 20% of the height 33 of the waveguide member 30.

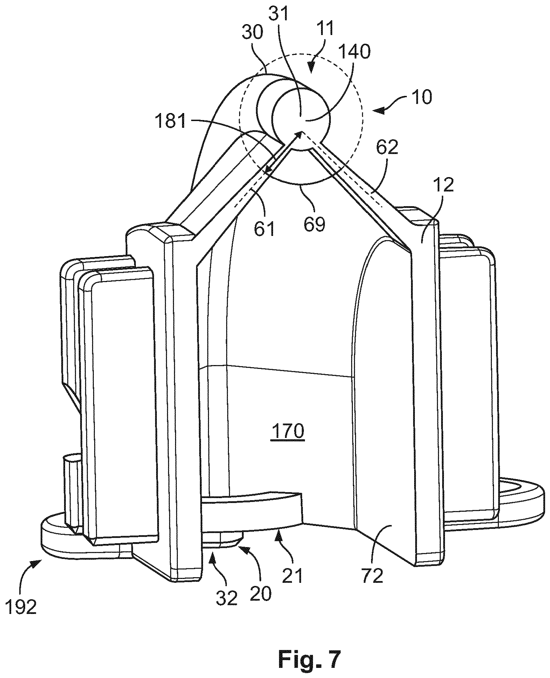

In the embodiment shown in Fig. 7, the waveguide member 30 has a circular cross-section. Again, in a cross-section, any part 61, 62 of the support structure 60 extending away from the waveguide member 30 makes up less than 10 degrees, preferably less than 5 degrees.

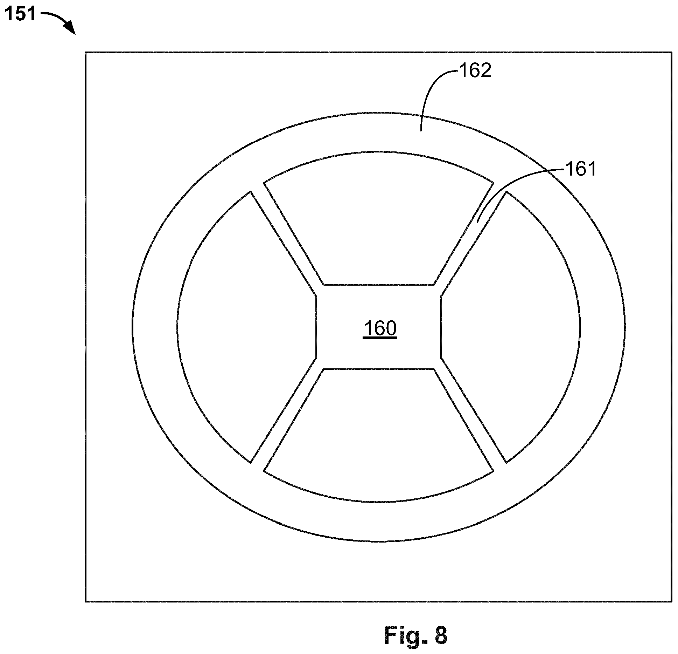

In Figs. 8 to 10, several embodiments of an external element 150 that can be attached to the redirecting device 100 are shown.

In Fig. 8, a first embodiment 151 is shown, which comprises a core 160 with a rectangular cross-section that is held in the center of a supporting ring 162 by support members 161.

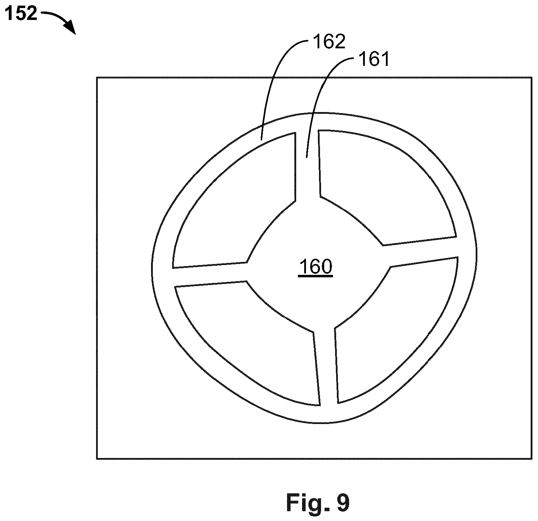

The second embodiment 152 shown in Fig. 9 comprises a core 160 with a square shaped cross-section, which is also held within a support ring 162 by support members 161.

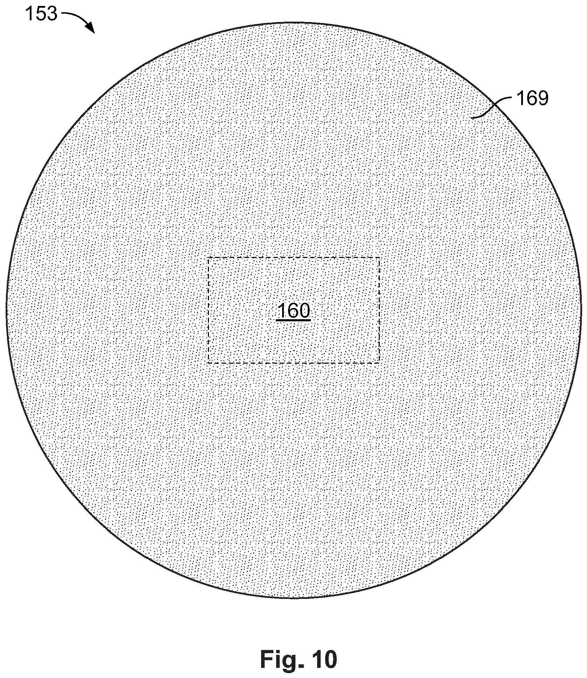

In Fig. 10, a third embodiment 53 is shown in which a core 163 is located in the foam 169. The foam 169 has a low permittivity such that the waves are restrained within the core 160.

### REFERENCE NUMERALS

- 10: input section
- 11: coupling face
- 12: first mounting plane
- 20: output section
- 21: coupling face
- 22: second mounting plane
- 30: waveguide member
- 31: end surface
- 32: end surface
- 33: curve
- 34: radius of curve
- 35: inner side of curve
- 36: minimum curvature radius
- 37: thickness
- 39: elongated element
- 41: length of waveguide member
- 42: width of waveguide member
- 43: height of waveguide member
- 45: center of waveguide member
- 50: cross section
- 51: rectangle
- 52: corner
- 60: support structure
- 61: first part
- 62: second part
- 66: thickness part
- 67: angle part
- 69: angle first part - second part
- 71: first wall section
- 72: second wall section
- 100: redirecting device
- 110: first external member
- 120: second external member
- 121: PCB
- 131: length direction
- 132: width direction
- 133: height direction
- 140: cross section
- 150: waveguide
- 151: first embodiment of a waveguide
- 152: second embodiment of a waveguide
- 153: third embodiment of a waveguide
- 160: core
- 161: support member
- 169: foam
- 170: air cladding
- 180: distance
- 181: distance
- 183: distance
- 185: board member
- 190: housing
- 191: fixing element
- 192: fixing element
- 195: plug
- 196: fixing element
- 200: connector assembly

## Claims

1. Redirecting device (100) for mm-waves, comprising an input section (10), an output section (20), and a rigid, dielectric waveguide member (30) extending from the input section (10) to the output section (20), wherein the input section (10) and the output section (20) are at 90 degrees to each other, wherein the redirecting device (100) comprises a support structure (60) for supporting the waveguide member (30), wherein the redirecting device (100) is a monolithically moulded piece, and a part (61, 62) of the support structure (60) extending away from the waveguide member (30) tapers towards the waveguide member (30).

2. Redirecting device (100) according to claim 1, wherein the waveguide member (30) is an elongated element.

3. Redirecting device (100) according to claim 1 or 2, wherein the waveguide member (30) has a constant cross-section (140).

4. Redirecting device (100) according to one of claims 1 to 3, wherein a minimum curvature radius (36) of the waveguide member (30) is greater than one wavelength.

5. Redirecting device (100) according to one of claims 1 to 4, wherein the support structure (60) extends along the waveguide member (30) from the input section (10) to the output section (20).

6. Redirecting device (100) according to one of claim 1 to 5, wherein the input section (10) defines a first mounting plane (12) and/or the output section (20) defines a second mounting plane (22) and the support structure (60) extends from the waveguide member (30) to the first mounting plane (12) and/or the second mounting plane (22).

7. Redirecting device (100) according to one of claims 1 to 6, wherein apart from the input section (10), the output section (20) and the support structure (60) no further material is present next to the waveguide member (30).

8. Redirecting device (100) according to one of claims 1 to 7, wherein in a cross-section the thickness (66) of a part (61, 62) of the support structure (60) extending away from the waveguide member (30) is less than 20 % of a maximum thickness (37) of the waveguide member (30).

9. Redirecting device (100) according to one of claims 1 to 8, wherein in a cross-section any part (61, 62) of the support structure (60) extending away from the waveguide member (30) makes up less than 10 degrees, preferably less than 5 degrees, wherein the angle is measured at a distance of 1.0 times the wavelength away from the waveguide member taking the center of the waveguide member as the vertex of the angle.

10. Redirecting device (100) according to one of claims 1 to 9, wherein the support structure (60) is arranged at an inner side (35) of a curve (33) of the waveguide member (30).

11. Connection assembly (200) comprising a redirecting device according to any one of claims 1 to 10, further comprising a housing element (190), wherein the housing element (190) is spaced at least 1 time the wavelength away from the waveguide member (100), at any point.

## Patentansprüche

1. Ablenkvorrichtung (100) für Millimeterwellen, umfassend einen Eingangsabschnitt (10), einen Ausgangsabschnitt (20) und ein starres, dielektrisches Wellenleiterelement (30), das sich von dem Eingangsabschnitt (10) zu dem Ausgangsabschnitt (20) erstreckt, wobei der Eingangsabschnitt (10) und der Ausgangsabschnitt (20) in einem Winkel von 90 Grad zueinander stehen, wobei die Ablenkvorrichtung (100) eine Stützstruktur (60) zum Stützen des Wellenleiterelements (30) umfasst, wobei die Ablenkvorrichtung (100) ein monolithisch geformtes Stück ist, und ein Teil (61, 62) der Stützstruktur (60), der sich von dem Wellenleiterelement (30) weg erstreckt, sich zu dem Wellenleiterelement (30) hin verjüngt.

2. Ablenkvorrichtung (100) nach Anspruch 1, wobei das Wellenleiterelement (30) ein längliches Element ist.

3. Ablenkvorrichtung (100) nach Anspruch 1 oder 2, wobei das Wellenleiterelement (30) einen konstanten Querschnitt (140) aufweist.

4. Ablenkvorrichtung (100) nach einem der Ansprüche 1 bis 3, wobei ein minimaler Krümmungsradius (36) des Wellenleiterelements (30) größer als eine Wellenlänge ist.

5. Ablenkvorrichtung (100) gemäß einem der Ansprüche 1 bis 4, wobei sich die Stützstruktur (60) entlang des Wellenleiterelements (30) von dem Eingangsabschnitt (10) zu dem Ausgangsabschnitt (20) erstreckt.

6. Ablenkvorrichtung (100) gemäß einem der Ansprüche 1 bis 5, wobei der Eingangsabschnitt (10) eine erste Montageebene (12) definiert und/oder der Ausgangsabschnitt (20) eine zweite Montageebene (22) definiert und die Stützstruktur (60) sich von dem Wellenleiterelement (30) zu der ersten Montageebene (12) und/oder der zweiten Montageebene (22) erstreckt.

7. Ablenkvorrichtung (100) nach einem der Ansprüche 1 bis 6, wobei neben dem Eingangsabschnitt (10), dem Ausgangsabschnitt (20) und der Stützstruktur (60) kein weiteres Material neben dem Wellenleiterelement (30) vorhanden ist.

8. Ablenkvorrichtung (100) gemäß einem der Ansprüche 1 bis 7, wobei in einem Querschnitt die Dicke (66) eines Teils (61, 62) der Stützstruktur (60), der sich von dem Wellenleiterelement (30) weg erstreckt, weniger als 20 % einer maximalen Dicke (37) des Wellenleiterelements (30) beträgt.

9. Ablenkvorrichtung (100) gemäß einem der Ansprüche 1 bis 8, wobei in einem Querschnitt jeder Teil (61, 62) der Stützstruktur (60), der sich von dem Wellenleiterelement (30) weg erstreckt weniger als 10 Grad, vorzugsweise weniger als 5 Grad, beträgt, wobei der Winkel in einer Entfernung von der 1,0-fachen Wellenlänge von dem Wellenleiterelement entfernt gemessen wird, wobei die Mitte des Wellenleiterelements als Scheitelpunkt des Winkels genommen wird.

10. Ablenkvorrichtung (100) gemäß einem der Ansprüche 1 bis 9, wobei die Stützstruktur (60) an einer Innenseite (35) einer Krümmung (33) des Wellenleiterelements (30) angeordnet ist.

11. Verbindungsanordnung (200), die eine Ablenkvorrichtung gemäß einem der Ansprüche 1 bis 10 umfasst, ferner umfassend ein Gehäuseelement (190), wobei das Gehäuseelement (190) an jedem Punkt mindestens um das 1-fache der Wellenlänge vom Wellenleiterelement (100) beabstandet ist.

## Revendications

1. Dispositif de redirection (100) pour ondes millimétriques, comprenant une section d'entrée (10), une section de sortie (20) et un élément guide d'ondes diélectrique rigide (30) s'étendant de la section d'entrée (10) à la section de sortie (20), dans lequel la section d'entrée (10) et la section de sortie (20) sont à 90 degrés l'une de l'autre, dans lequel le dispositif de redirection (100) comprend une structure de support (60) pour supporter l'élément guide d'ondes (30), dans lequel le dispositif de redirection (100) est une pièce moulée de manière monolithique, et une partie (61, 62) de la structure de support (60) s'étendant à l'opposé de l'élément guide d'ondes (30) se rétrécit vers l'élément guide d'ondes (30).

2. Dispositif de redirection (100) selon la revendication 1, dans lequel l'élément guide d'ondes (30) est un élément allongé.

3. Dispositif de redirection (100) selon la revendication 1 ou 2, dans lequel l'élément guide d'ondes (30) a une section transversale constante (140).

4. Dispositif de redirection (100) selon l'une des revendications 1 à 3, dans lequel un rayon de courbure minimal (36) de l'élément guide d'ondes (30) est supérieur à une longueur d'onde.

5. Dispositif de redirection (100) selon l'une des revendications 1 à 4, dans lequel la structure de support (60) s'étend le long de l'élément guide d'ondes (30) de la section d'entrée (10) à la section de sortie (20).

6. Dispositif de redirection (100) selon l'une des revendications 1 à 5, dans lequel la section d'entrée (10) définit un premier plan de montage (12) et/ou la section de sortie (20) définit un second plan de montage (22) et la structure de support (60) s'étend de l'élément guide d'ondes (30) au premier plan de montage (12) et/ou au second plan de montage (22).

7. Dispositif de redirection (100) selon l'une des revendications 1 à 6, dans lequel, mis à part la section d'entrée (10), la section de sortie (20) et la structure de support (60), aucun autre matériau n'est présent à côté de l'élément guide d'ondes (30).

8. Dispositif de redirection (100) selon l'une des revendications 1 à 7, dans lequel, en coupe transversale, l'épaisseur (66) d'une partie (61, 62) de la structure de support (60) s'étendant à l'opposé de l'élément guide d'ondes (30) est inférieure à 20% d'une épaisseur maximale (37) de l'élément guide d'ondes (30).

9. Dispositif de redirection (100) selon l'une des revendications 1 à 8, dans lequel, en coupe transversale, toute partie (61, 62) de la structure de support (60) s'étendant à l'opposé de l'élément guide d'ondes (30) représente moins de 10 degrés, de préférence moins de 5 degrés, dans lequel l'angle est mesuré à une distance de 1,0 fois la longueur d'onde par rapport à l'élément de guide d'ondes en prenant le centre de l'élément guide d'ondes comme sommet de l'angle.

10. Dispositif de redirection (100) selon l'une des revendications 1 à 9, dans lequel la structure de support (60) est agencée au niveau d'un côté intérieur (35) d'une courbe (33) de l'élément guide d'ondes (30).

11. Ensemble de connexion (200) comprenant un dispositif de redirection selon l'une quelconque des revendications 1 à 10, comprenant en outre un élément de boîtier (190), dans lequel l'élément de boîtier (190) est espacé d'au moins 1 fois la longueur d'onde par rapport à l'élément guide d'ondes (100), en tout point.
